# EUROPEAN PATENT APPLICATION

(11) **EP 2 747 144 A1**
(43) Date of publication of application: **25.06.2014**
(21) Application number: 12198133.6
(22) Date of filing: 19.12.2012
(51) Int. Cl.: H01L 29/778, H01L 29/207, H01L 23/29, H01L 23/31, H01L 29/20

(54) **Gate leakage of GaN HEMTs and GaN diodes**

(71) Applicant: NXP B.V., 5656 AG Eindhoven (NL)
(72) Inventor: Croon, Jeroen, Redhill Surrey RH1 1NY (GB); Hurkx, Godefridus, Redhill Surrey RH1 1NY (GB); Delhougne, Romain, Redhill Surrey RH1 1NY (GB); Donkers, Johannes, Redhill Surrey RH1 1NY (GB); Mueller, Markus, Redhill Surrey RH1 1NY (GB); Jansman, Andreas, Redhill Surrey RH1 1NY (GB); Heil, Stephan, Redhill Surrey RH1 1NY (GB)
(74) Representative: Crawford, Andrew

(57) **Abstract**

A GaN heterojunction device (and method) has a region at the gate edge processed differently to provide a region which enables a reduction in leakage currents.

## Description

This invention relates to GaN devices, such as high electron mobility transistors (HEMTs) and diodes, and relates to the problem of gate leakage in these devices.

In recent years, GaN high-mobility transistors (HEMTs) and Schottky diodes have drawn a lot of attention regarding their high potential to replace Si or SiC for use as High Voltage (HV) devices as result of their enhanced high-power performance. This follow from the inherent high-density two-dimensional electron gas (2DEG), high electron mobility, and high critical breakdown electric field. As a consequence, the wide bandgap AlGaN/GaN HEMTs are emerging as excellent candidates for radio-frequency (RF) and microwave power amplifiers.

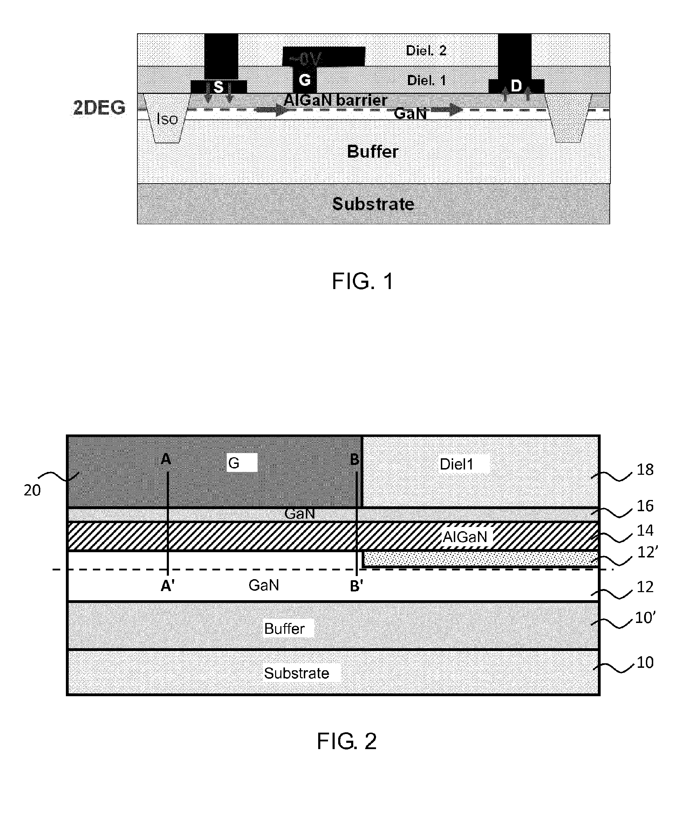

The basic structure of a HEMT is shown in Figure 1. The current flows between drain (D) and source (S) via the so-called two-dimensional electron gas (2DEG) that is formed at the interface between an AlGaN barrier layer and a top GaN layer.

This heterojunction structure incorporates a junction between two materials with different band gaps as the channel instead of a doped region.

In the framework of AlGaN/GaN heterostructures, there is often no dopant required due to the strong spontaneous and piezoelectric polarization effect in such systems. For example, electrons from surface donors can be swept into the GaN channel by the intrinsic polarization induced electric field. In this instance, the electrons can move quickly without colliding with any impurities, due to the unintentionally doped (e.g., not intentionally doped) layer's relative lack of impurities or dopants, from which the electrons cannot escape.

The net result of such a heterojunction is to create a very thin layer of highly mobile conducting electrons with very high concentration or density, giving the channel very low resistivity. This layer is known as the two-dimensional electron gas (2DEG). This effect for instance can be utilized in a field-effect transistor (FET), where the voltage applied to the Schottky gate alters the conductivity of this layer to form transistor structures.

One kind of such a transistor is a high-electron mobility transistor (HEMT) including Gallium Nitride and is known as an Aluminum Gallium Nitride/Gallium Nitride (AlGaN/GaN) HEMT. Typically, AlGaN/GaN HEMTs can be fabricated by growing crystalline films of GaN, AlGaN, etc. on a substrate, e.g., sapphire, silicon (Si)(111), silicon carbide (SiC) and so on, through an epitaxial crystal growth method, e.g., metal organic chemical vapor deposition (MOCVD), molecular beam epitaxy (MBE) and so on, and processing the epitaxial substrate thus grown, to form the desired structures.

In some devices, the semiconductor device is switched between the off-state, in which the 2DEG is disrupted under the Schottky gate, and an on-state in which a high current is produced at a low voltage. The design of such devices typically targets a trade-off between power losses in the on-state, off-state and during switching.

Switching-off is achieved by applying a suitable voltage on the Schottky metal (G) such that the 2DEG under the metal disappears. A GaN Schottky diode can be simply thought of as a HEMT without a source contact. In a Schottky diode the current flows between gate and drain.

One of the problems with such devices is a high leakage current during the off-state. Such a leakage current is determined by the potential barrier for electrons between the Schottky metal and the 2DEG.

According to the invention there is provided an apparatus and method as defined in the claims.

In one aspect, the invention provides a GaN hetereojunction semiconductor device comprising:
a substrate;
a layer structure having a first layer having a first bandgap and a second layer having a second bandgap, wherein the first layer is located between the substrate and the second layer; and
a Schottky gate electrode and a first further electrode each conductively coupled to a different area of the heterojunction, said Schottky gate electrode comprising a central region and an edge region,
wherein the Schottky gate electrode comprises a lowermost portion which is co-planar with a first dielectric layer over the second layer, and wherein:
   the first dielectric layer comprises portions adjacent the lowermost gate portions which have different structure to the remainder of the first dielectric layer; or
   the top of the layer structure comprises portions adjacent the lowermost gate portions which are processed to have different structure to the remainder of the top of the layer structure.

In this device, a region at the gate edge, which may be the dielectric layer to the side of the gate edge or the hetereojunction structure beneath the gate edge, is processed differently to provide a region which enables a reduction in leakage currents. The gate electrode lowermost portion is the conventional gate foot, and there is a gate head above.

In a first example, the dielectric layer has the processed portions and these first dielectric layer portions comprise portions where the dielectric layer is removed. Alternatively, the dielectric layer may not be deposited in these areas, or else a different material can be used next to the gate. Thus, it will be clear that the term "different structure" in connection with different areas of a layer structure is intended to include absence of any structure at that part of the layer.

In a second example, the dielectric layer has the processed portions and these first dielectric layer portions comprise portions where negative charges are incorporated into the first dielectric layer close to the edge of the lowermost gate region.

In a third example, the dielectric layer has the processed portions and the first dielectric layer has positive charges incorporated everywhere other than close to the edge of the lowermost gate portion. The first portions are thus regions of no incorporated positive charge compared to the remainder of the dielectric layer.

In a fourth example, the hetereojunction layer structure has the processed portions. The top of the layer structure comprises the second layer, and it has portions with negative charges incorporated close to the edge of the lowermost gate portion.

In a fifth example, the hetereojunction layer structure has the processed portions. The top of the layer structure comprises the second layer, and it has positive charges incorporated everywhere other than close to the edge of the lowermost gate portion. The layer structure portions are thus regions of no incorporated positive charge compared to the remainder of the second layer.

In a sixth example, the hetereojunction layer structure has the processed portions. The top of the layer structure comprises a capping layer over the second layer, and the capping layer can have different surface treatments near the gate and further from the gate.

In all cases, the first dielectric layer can comprise SiO or SiN, the first layer can comprise GaN and the second layer can comprise AlGaN.

The portions with different processing can extend across the full gate width, or else they can comprise a set of discrete portions spaced along the gate width.

Another aspect of the invention provides a method of manufacturing a semiconductor device comprising:
providing a substrate carrying a layer structure having a first layer having a first bandgap and a second layer having a second bandgap, wherein the first layer is located between the substrate and the second layer, the interface between the first layer and second layer defining a heterojunction;
forming a dielectric layer over the second layer;
forming a Schottky gate electrode and a first further electrode each conductively coupled to a different area of the heterojunction, said Schottky gate electrode comprising a central region and an edge region, wherein the Schottky gate electrode comprises a lowermost portion which is co-planar with a first dielectric layer over the second layer, wherein the method comprises:
   forming portions in the first dielectric layer adjacent the lowermost gate portions with different structure to the remainder of the first dielectric layer; or
   forming portions in the top of the layer structure adjacent the lowermost gate portions with different structure to the remainder of the top of the layer structure.

The method can comprise processing the dielectric layer, by:
removing the dielectric layer to define the portions; or
implanting negative charges into the first dielectric layer close to the edge of the lowermost gate region to define the portions; or
implanting positive charges into the dielectric layer everywhere other than close to the edge of the lowermost gate portion.

Alternatively, the method can comprise processing the heterojunction layer structure, wherein the top of the layer structure comprises the second layer, by:
forming portions with negative charges incorporated close to the edge of the lowermost gate portion; or
forming positive charges incorporated everywhere other than close to the edge of the lowermost gate portion.

Examples of the invention will now be described in detail with reference to the accompanying drawings, in which:

Examples of the invention will now be described in detail with reference to the accompanying drawings, in which:
Figure 1 shows a known structure of a GaN HEMT;
Figure 2 shows the gate area of the GaN HEMT of Figure 1 in more detail;
Figures 3 and 4 depict the effect of the gate bias on the potential barrier for electrons tunneling between the Schottky gate and the 2DEG layer;
Figure 5 shows leakage current behaviour;
Figure 6(a) shows a typically observed trade-off between leakage current and on-state resistance and Figure 6(b) shows the simulated trade-off by varying an amount of positive charge;
Figure 7 shows how leakage can be reduced by removing the nitride covering the GaN cap next to the gate;
Figure 8 shows a first device of the invention and the associated leakage current;
Figure 9 shows the leakage current for no nitride next to the gate (Figure 9(a)) compared to the case where the gate is adjacent the nitride (Figure 9(b));
Figure 10 shows how an estimate of the sheet-resistance can be made;
Figure 11 shows various devices in accordance with the invention;
Figure 12 shows a modification which can be applied to the devices of Figure 11.

The invention provides a device (and method) in which a region at the gate edge is processed differently to provide a region which enables a reduction in leakage currents.

Before describing the invention, an analysis of the problem of leakage currents is examined, and this examination forms the basis of the invention. The problem and the solution described below holds for both a HEMT and a Schottky diode. For the Schottky diode, it is assumed that the gate voltage is kept at zero and the drain voltage is ramped up to e.g. 600 V while for a HEMT the source is kept at zero volts, the gate voltage is negative (below the threshold voltage) and the drain voltage is ramped up to e.g. 600 V.

The leakage current is determined by the potential barrier for electrons between the Schottky metal and the 2DEG layer. It has been experimentally found that under the condition that V_{g} is below the threshold voltage Vₜₕ, i.e. when the 2DEG under the metal has vanished, the leakage current is flowing predominantly near the metal edge. This can be understood based on the fact that under reverse bias, the Schottky leakage current is dominated by tunnelling of electrons from the metal to the semiconductor.

Figure 2 shows the gate area of the device of Figure 1 in more detail. A silicon substrate 10 comprises a GaN buffer layer 10' on which an epitaxially grown GaN layer 12 and an AlGaN barrier layer 14 are formed. The GaN layer 12 and the AlGaN barrier layer 14 define a heterojunction, at the interface of which a 2DEG 12' may form. A GaN capping layer 16 (which is optional and is not shown in Figure 1) separates the first (Si₃N₄) dielectric layer 18 and a Schottky gate 20 from the heterojunction.

The semiconductor device typically will comprise at least one other (ohmic) electrode, to form a Schottky diode in case of a two-terminal device or two other electrodes in the case of a three-terminal HEMT device, but these electrodes are omitted from Figure 2 for the sake of clarity only.

The semiconductor device typically has an on-state, in which the 2DEG 12' laterally extends over the full length of the device, e.g. between the source and drain of a HEMT, and an off-state, in which a (negative) bias or gate voltage is applied to the Schottky gate to disrupt the 2DEG 12' underneath the Schottky gate 20. This is the situation shown in Figure 2, where the 2DEG 12' aligns with the edge of the Schottky gate 20, i.e. the interface between the Schottky gate 20 and the dielectric layer 18.

In a normally-on device, the 2DEG 12' extends over the full width of the device in the absence of a gate bias. In a normally-off device, the 2DEG 12' is absent underneath the Schottky gate 20 in the absence of a gate bias.

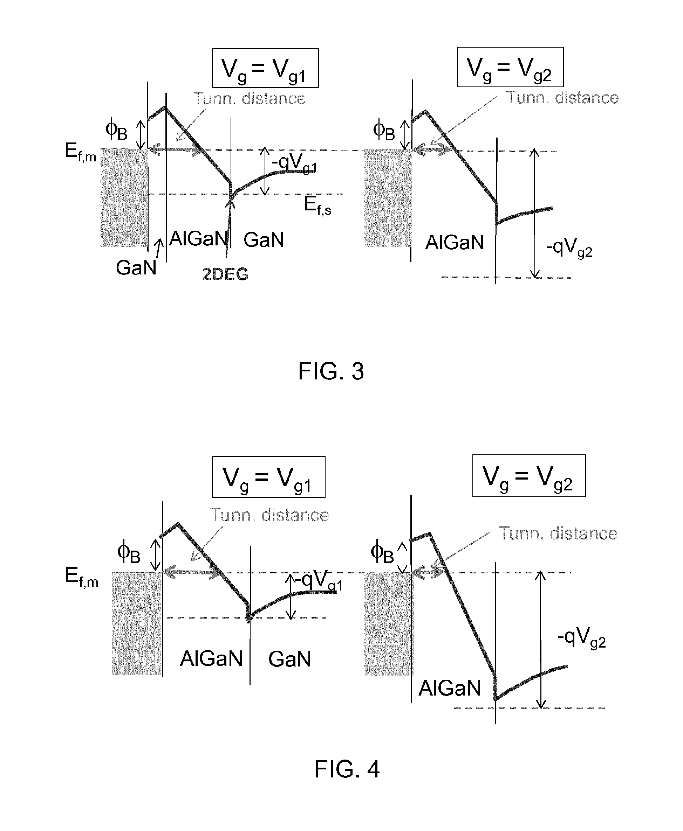

Figures 3 and 4 depict the effect of the gate bias on the potential barrier for electrons tunneling between the Schottky gate 20 and the 2DEG 12' along the line A-A' and B-B' respectively in Figure 2 at two different gate voltages V_{g1} and V_{g2}, where V_{g1}>Vₜₕ and V_{g2}<Vₜₕ, with Vₜₕ being the threshold voltage of the device. The bias voltage on the ohmic contacts was kept at 0V.

Figure 3 thus shows the conditions near the gate middle and Figure 4 shows the conditions at the gate edge.

The plots in Figures 3 and 4 are applicable to a Schottky diode as well as to a HEMT. V_{g1} typically corresponds to an on-state of the device, and V_{g2} typically corresponds to an off-state of the device.

For V_{g1}, the 2DEG 12' is still present underneath the Schottky gate 20 such that the conduction band minimum is pinned at the electron Fermi level in the GaN semiconductor layer 12. In contrast, for V_{g2} the 2DEG 12' is absent underneath the Schottky gate 20 such that the conduction band minimum is no longer pinned. As a result, the tunneling distance from the bottom edge of the Schottky gate 20 to the barrier layer 14 does not significantly increase with an increasing reverse Schottky voltage once the 2DEG is gone, i.e. below Vₜₕ.

Consequently, the leakage current density under the Schottky gate 20 far from the edge increases strongly for V_{g}> Vₜₕ and remains fairly constant below Vₜₕ.

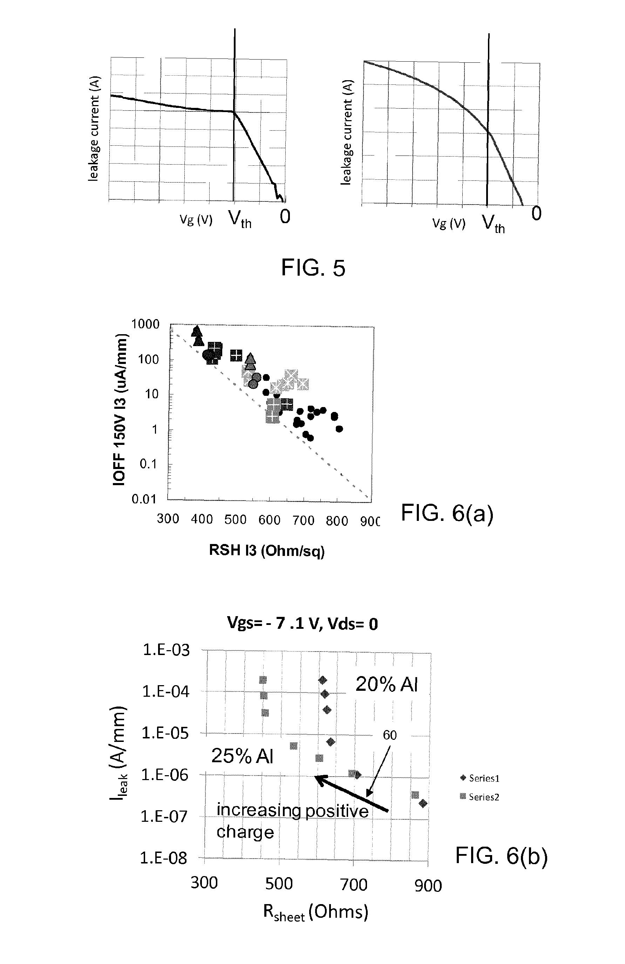

Figure 5 shows a sketch of the leakage current behaviour. Figure 5(a) is for a very large gate area where the area contribution dominates for voltages around the threshold voltage, and Figure 5(b) is for a small gate area where the edge contribution dominates for voltages around the threshold voltage. Note that the gate voltage and threshold voltage are negative. The vertical scale is logarithmic.

The behaviour explained above which arises in the middle of the gate, i.e. along line A-A', is shown in Figure 5(a).

A different behaviour is observed at the gate edge, i.e. along the line B-B' in Figure 2. This behaviour is shown in Figure 4 and Figure 5(b). The dependence of the tunneling distance on the reverse voltage is the same for V_{g} > Vₜₕ, e.g. for V_{g} = V_{g1}. However, for V_{g} < Vₜₕ a different behavior is observed because the 2DEG 12' is still present underneath the edge the metal Schottky gate 20.

This means that in this region the conduction band minimum is still pinned at the Fermi level for V_{g} < Vₜₕ, which implies that there is a transition region underneath the Schottky gate 20 near its edge where the conduction band minimum gradually decreases from its value far from the edge towards the semiconductor Fermi level.

As a result, the tunneling distance near the edge of the Schottky gate 20 (i.e. along the line B-B') is smaller than far from its edge (i.e. along the line A-A') and, hence, the tunneling current density is drastically higher near the edge of the Schottky gate 20, as shown in Figure 4, right hand pane, which furthermore keeps on increasing with decreasing V_{g}, as shown in Figure 5(b). This edge effect leads to large leakage currents flowing in the off state of the device.

If, subsequently, V_{g} is further decreased to a high negative value, e.g. 600 V, the electric field at the metal edge keeps on increasing until the 2DEG in the region adjacent to the metal has gone. Hence, the leakage current increases until the 2DEG in this region has vanished.

The invention is based on reducing the edge leakage current based on these observations.

The edge leakage current can basically by reduced in two ways. The first one is by preventing or reducing the above-mentioned pinning of the conduction band minimum to the Fermi level near the gate edge. The second one is by increasing the barrier thickness or barrier height. Typically these ways of achieving leakage reduction would affect the entire HEMT/diode or the entire region between source and gate and drain and gate. Besides reducing leakage, also other properties of the device are affected of which some in a negative way.

Figure 6(a) shows a typically observed trade-off between leakage current and on-state resistance for different process conditions and barrier heights/thicknesses. In order to minimize the impact on other transistor parameters besides leakage, this invention aims to reduce the pinning or to increase the barrier height/thickness only in a limited region of the device where it helps to reduce leakage, i.e. around the gate edge, but not across the entire device. In this way, the trade off with on-state resistance is improved.

Figure 6(b) shows the simulated trade-off by varying the amount of positive charge on the interface between the GaN-capping layer and nitride first dielectric layer. Arrow 60 represents increasing the positive charge. Adding more positive charge increases the 2DEG concentration (i.e. reduces the on-state resistance) until the potential at the GaN-cap/nitride interface is pinned by the surface-traps. However, the positive charge also increases the voltage at which the leakage current at the edge of the transistor saturates, thus leading to higher leakage.

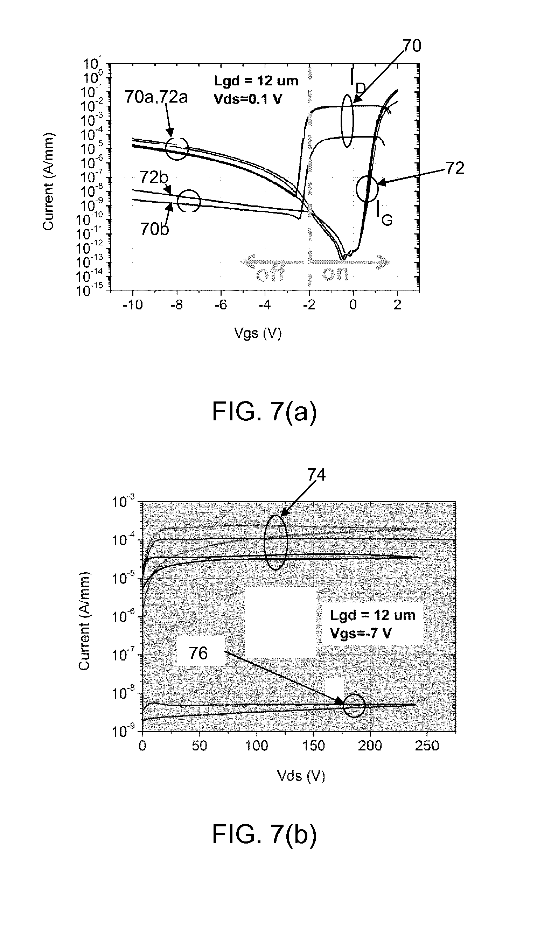

Figure 7 shows that the leakage is reduced significantly (in this case by approximately four orders of magnitude) by using a (dry) etch to remove the nitride covering the GaN cap next to the gate. This represents a first approach of the invention.

It is assumed for simulation purposes that a small GaN-cap covers the AlGaN layer, but the idea is also valid in case the AlGaN layer does not have a GaN cap on top of it.

Figure 7(a) shows the leakage current for different nitride processes (top and in case the nitride is removed with a dry etch. The curves 70 represent the drain current for different processes and the curves 72 represent the gate current. The group 70a,72a represent different nitride processes. In particular, a 3 layer nitride stack is modelled, and the three curves in the group 70a,72a represent the use of one, two or all three layers. Curve 70b is the drain current plot for no nitride and curve 72b is the gate current plot for no nitride.

Figure 7(b) shows the leakage at low reverse bias and the on state current, again for different nitride processes (curves 74) and in case the nitride is removed with a dry etch (curves 76). The two curves 76 are for the leakage and on state current with no nitride, and the curves 74 comprise three pairs of curves for the leakage and on state current for the different nitride designs as in Figure 7(a) (although the curves overlaps in the case of the conventional dielectric).

While the leakage is reduced, at the same time an increase in on-state resistance is observed, in this case one to two orders of magnitude.

Furthermore, it is also seen that having no nitride next to the gate could lead to an increase in the dynamic on-resistance (this is the on-resistance after switching from the off-state). Theoretically, the trade-off between on-state can be understood by assuming that the nitride adds positive charge above the GaN-cap/nitride interface or at this interface.

An alternative to the removal of the nitride is modification of the dielectric layer in the vicinity of the gate edge, or modification of the top of the hetereojunction layer structure in the vicinity of the gate edge, to reduce leakage currents.

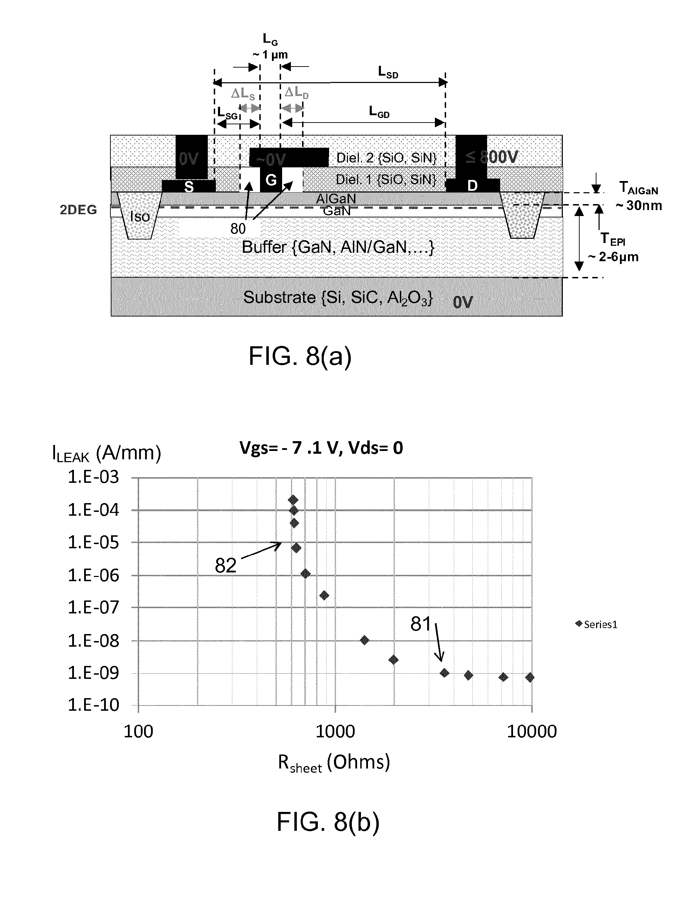

As outlined above, a first approach in accordance with the invention involves improving the leakage/on-resistance trade-off, by removing only the nitride next to the gate (over a certain length ΔL_{S} to the source side and ΔL_{D} to the drain side), as schematically illustrated in Figure 8(a).

The difference compared to Figure 1 is that the first dielectric layer 18 (SiO or SiN) is removed from each side of the gate G to form regions 80 shown in Figure 8(a). This achieves the same reduction in leakage current as when completely removing the nitride, while the increase in on-state resistance reduces to the fraction (Δ*L_{S}*+Δ*L_{D})*/*L_{SD}* of the original increase.

Figure 8(b) shows a simulation of leakage current version sheet-resistance. Region 81 corresponds to the area next to the gate with low leakage and area 82 corresponds to the area not next to the gate with low on-state resistance.

A large increase in on-state resistance as observed in Figure 7, when removing a portion of the nitride layer, might partially be due to the etch recipe. Using a different edge-recipe would impact the on-state resistance less severely, but based on the theoretical analysis a significant improvement is still to be expected.

ΔL_{S} and ΔL_{D} typically will be chosen to be at least a few times (e.g. 2 to 5) the thickness of the first nitride layer. The total device length L_{SD} depends on the application, and may typically range from one or a few microns to around 20 microns.

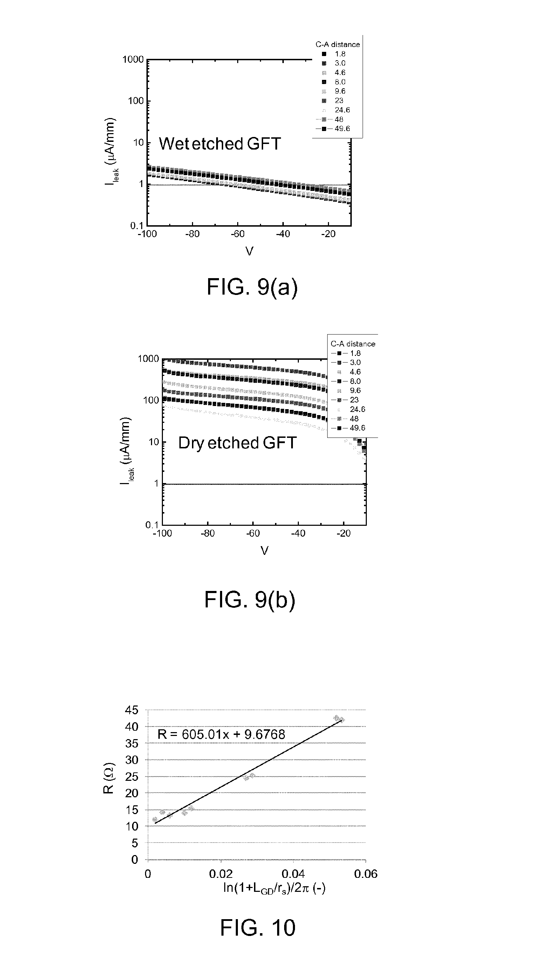

Figure 9 shows that the leakage current is significantly lower when there is no nitride next to the gate (Figure 9(a)) compared to the case where the gate is adjacent the nitride (Figure 9(b)).

Figure 9 shows different plots for different cathode to anode (C-A) distance.

This cathode-anode distance is the distance between the egde of the gate foot (at the drain side) and the drain. This can vary from one or a few microns to around 20 microns.

An estimate of the sheet-resistance is made by looking at the linear part of the forward diode current, as shown in Figure 10. A sheet resistance of about 600Ω per square is observed. The resistance is extracted from the forward current of circular Schottky diodes for increasing anode-cathode distance.

This is close to the sheet resistance measured using dedicated test structures (nitride everywhere), which means that the increase in sheet resistance is either small or negligible.

It should be noted that the process to etch the gate foot in the silicon nitride can be achieved in different ways. A wet etch (buffered oxide etch) can be used, or a dry etch SF₆.

The example above is based on removing the nitride next to the gate. However, the same or similar results can be achieved by using a different nitride (or different processing conditions) next to the gate, or using a different treatment of the GaN-capping layer next to the gate.

In addition to the experimental observation, a theoretical basis of this approach can be derived.

The leakage vs. on-resistance trade-off is improved by introducing a different amount of charge next to the gate, as compared to the rest of the device.

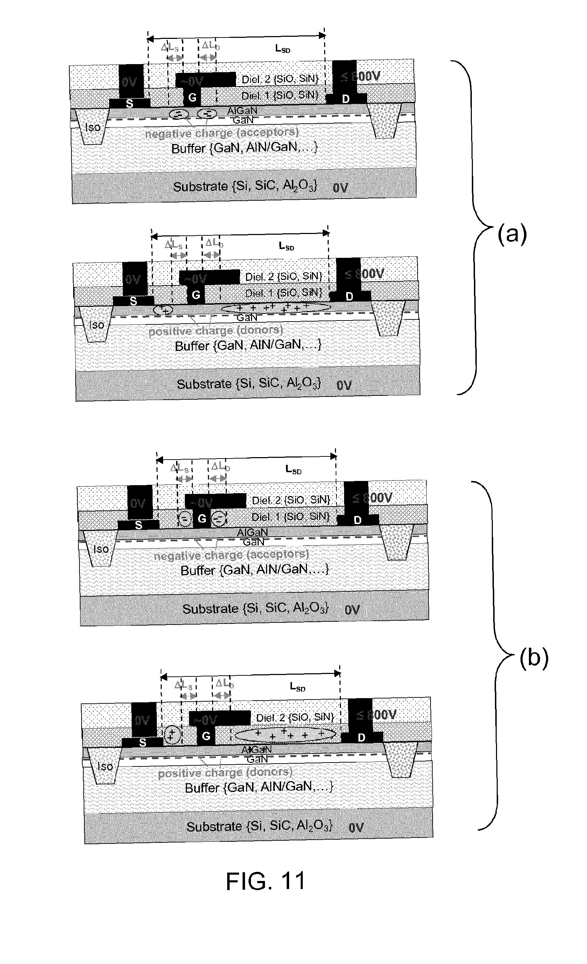

The charge does not necessarily have to be located at the interface between the GaN capping layer and the SiN dielectric layer. It can for instance also be located above the interface in the nitride itself, or below the interface in the AlGaN/GaN layer. Several possibilities will now be discussed on how to optimize the leakage vs. on-resistance trade-off:
1. Using no nitride, a different nitride or a different material close to the gate edge.
   This results in a different amount of charge in the 'nitride' close to the gate edge or at the interface close to the gate-edge.
2. Realization of negative charge (i.e. implantation of acceptors) into the AlGaN/GaN layers close to the gate edge or having a base process with low leakage and higher on-resistance and reducing the on-resistance by realization of positive charge (i.e. implantation of donors) everywhere except at the gate-edge. These two options are shown in Figure 11 (a).
3. Implanting negative charge into the nitride close to the gate-edge or implanting positive charge in the nitride that is not immediately next to the gate-edge in combination with a base process with low leakage / higher on-resistance. These two options are shown in Figure 11 (b).
4. A different treatment of the GaN-cap (or AlGaN in case of no cap) surface close to the gate-edge could also lead to different charge/trap situation, i.e. achieving a lower leakage.

The mask for the gate head can be used in order to define the area next to the gate. However dedicated masks, spacers or other kinds of processing can also be used.

A second approach of the invention involves optimization of the device performance (leakage vs. on-resistance) by varying the device layout along the direction of the device width and close to the gate edge. This approach can be combined with the first approach.

In the first approach, the on-resistance vs. leakage trade-off of the device is improved by using different processing (nitride, implantation, charge layers, surface treatment, ...) close to the gate edge compared to the rest of the region between source and drain. The device can be uniform in the direction of the width of the device.

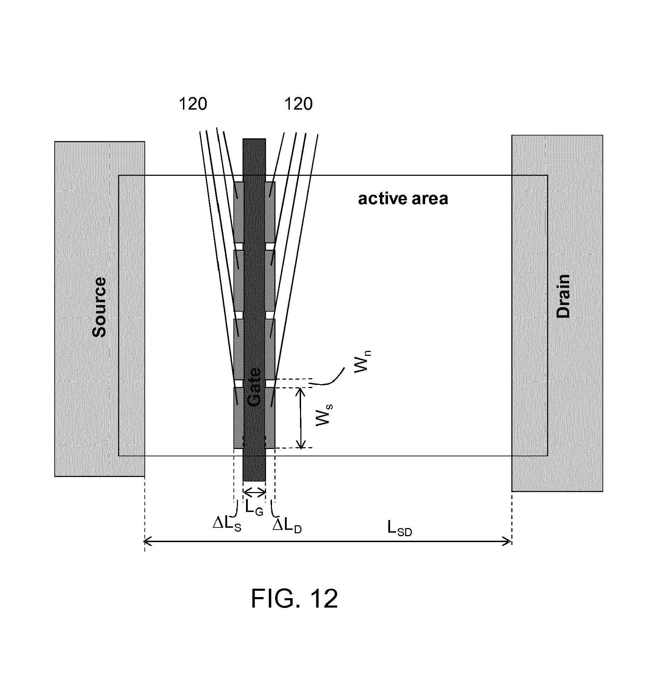

An alternative is to further optimize the device by also varying the device properties in the direction along the gate-width. The deviating process conditions at the gate edge are then restricted to a limited region along the gate-edge as schematically illustrated in the top view of Figure 12.

The doping levels required need to sufficient to influence the 2DEG.

In Figure 12, the gate width has regions 120 of reduced resistance. In this way, the dedicated gate-edge process to improve the leakage vs. on-resistance trade-off is not applied everywhere along the gate-edge.

This approach can be applied in cases where the on-state resistance at the gate-edge is too large. The localized regions at the gate-edge with lower resistance circumvent this issue at the cost of higher leakage.

The extreme case is where isolation is being used at most of the gate edge (zero leakage, infinite resistance). This would lead to a decrease in leakage of a factor *Wₙ*/*(Wₙ*+*Wₛ)* at the cost of an increase in on-resistance of ((Δ*L_{S}*+Δ*L_{D})*/*L_{SD}*)× *(Wₙ*+*Wₛ)*/*Wₙ.* In case the isolation would also be present under the gate itself the increase in on-state resistance would become ((Δ*L_{S}*+Δ*L_{D}*+*L_{G})*/*L_{SD}*)×(Wₙ+Wₛ)/Wₙ*.*

In some examples above, implantation of positive or negative charges is discussed. More generally, the different charges can be incorporated into the required regions by implanation or by other methods, such as by diffusion. In the case of a nitride, different nitrides can be deposited with different amounts of nitride charge to provide the desired effect.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

## Claims

1. A GaN hetereojunction semiconductor device comprising:
a substrate (10);
a layer structure having a first layer (12) having a first bandgap and a second layer (14) having a second bandgap, wherein the first layer is located between the substrate and the second layer; and
a Schottky gate electrode (20) and a first further electrode each conductively coupled to a different area of the heterojunction, said Schottky gate electrode comprising a central region and an edge region,
wherein the Schottky gate electrode comprises a lowermost portion which is co-planar with a first dielectric layer (18) over the second layer (14), and wherein:
the first dielectric layer (18) comprises portions (80) adjacent the lowermost gate portions which have different structure to the remainder of the first dielectric layer; or
the top (14 or 16) of the layer structure comprises portions adjacent the lowermost gate portions which are processed to have different structure to the remainder of the top of the layer structure.

2. A device as claimed in claim 1, wherein the first dielectric layer portions (80) comprise portions where the dielectric layer is removed or is not deposited.

3. A device as claimed in claim 1, wherein the first dielectric layer portions (80) comprise portions where negative charges are incorporated into the first dielectric layer close to the edge of the lowermost gate region.

4. A device as claimed in claim 1, wherein the first dielectric layer has positive charges incorporated everywhere other than close to the edge of the lowermost gate portion.

5. A device as claimed in claim 1, wherein the top of the layer structure comprises the second layer (14) and has portions with negative charges incorporated close to the edge of the lowermost gate portion.

6. A device as claimed in claim 1, wherein the top of the layer structure comprises the second layer (14) and has positive charges incorporated everywhere other than close to the edge of the lowermost gate portion.

7. A device as claimed in claim 1, wherein the top of the layer structure comprises a capping layer (16) over the second layer (14), and the capping layer has different surface treatments for portions near the gate and further from the gate.

8. A device as claimed in any preceding claim, wherein the first dielectric layer (180 comprises SiO or SiN.

9. A device as claimed in any preceding claim, wherein the first layer (12) comprises GaN and the second layer (14) comprises AlGaN.

10. A device as claimed in any preceding claim, wherein the portions with different processing comprise a set of discrete portions (120) spaced along the gate width.

11. A method of manufacturing a semiconductor device comprising:
providing a substrate (10) carrying a layer structure having a first layer (12) having a first bandgap and a second layer (14) having a second bandgap, wherein the first layer is located between the substrate and the second layer, the interface between the first layer and second layer defining a heterojunction;
forming a dielectric layer (18) over the second layer;
forming a Schottky gate electrode (20) and a first further electrode each conductively coupled to a different area of the heterojunction, said Schottky gate electrode comprising a central region and an edge region, wherein the Schottky gate electrode comprises a lowermost portion which is co-planar with a first dielectric layer (180 over the second layer, wherein the method comprises:
forming portions in the first dielectric layer (18) adjacent the lowermost gate portions with different structure to the remainder of the first dielectric layer; or
forming portions in the top (14 or 16) of the layer structure adjacent the lowermost gate portions with different structure to the remainder of the top of the layer structure.

12. A method as claimed in claim 11, comprising:
removing the dielectric layer (18) to define the portions; or
incorporating negative charges into the first dielectric layer close to the edge of the lowermost gate region to define the portions; or
incorporating positive charges into the dielectric layer everywhere other than close to the edge of the lowermost gate portion.

13. A method as claimed in claim 11, wherein the top of the layer structure comprises the second layer (14) and the method comprises:
forming portions in the second layer with negative charges incorporated close to the edge of the lowermost gate portion; or
forming positive charges in the second layer incorporated everywhere other than close to the edge of the lowermost gate portion.

14. A method as claimed in claim 11, wherein the top of the layer structure comprises a capping layer (16) over the second layer (14), and the method comprises processing the capping layer differently in different areas.

15. A method as claimed in any one of claims 11 to 14, wherein the first dielectric layer comprises SiO or SiN, the first layer comprises GaN and the second layer comprises AlGaN.
